Europäisches Patentamt

(19) European Patent Office

Office européen des brevets

(11) Publication number: **0 001 153**
**B1**

(12) **EUROPEAN PATENT SPECIFICATION**

(21) Application number: **78300018.5**

(22) Date of filing: **06.06.78**

(51) Int. Cl³: **H 01 L 23/36,**
**H 01 L 23/46, H 01 L 23/42**

(54) Cooling heat generating electrical components in an electrical apparatus

(30) Priority: **30.06.77 US 811740**

(43) Date of publication of application:
**21.03.79 Bulletin 79/06**

(45) Publication of the grant of the European patent:
**28.05.80 Bulletin 80/11**

(84) Designated Contracting States:
**DE FR GB**

(56) References cited:
**IBM TECHNICAL DISCLOSURE BULLETIN, vol. 18,
Otober 1975, New York,
S.P. ANTIPPAS: "Cooling cap for powder or liquid
filled modules", pages 1387 - 1388**

(73) Proprietor: **International Business Machines
Corporation
Armonk, N.Y. 10504 (US)**

(72) Inventor: **Antonetti, Vincent William
53, Colburn Drive
Poughkeepsie, New York 12603 (US)
Gupta, Omkarath Ramnath
10 Frederick Drive
Poughkeepsie, New York 12603 (US)**

(74) Representative: **Lewis, Alan J.
IBM United Kingdom Patent Operations,
Hursley Park
Winchester, Hants, SO21 2JN (GB)**

Courier Press, Leamington Spa, England.

Cooling heat generating electrical components in an electrical apparatus

The invention relates to cooled electrical apparatus, that is electrical apparatus comprising a plurality of heat generating electrical components and a plurality of heat-conducting piston-members respectively urged into contact with the components, slidably received in a plurality of cylinders or like openings in a heat-conducting housing and operative to conduct heat from the components to the housing. U.S. specification No. 3,993,123 discloses such electrical apparatus.

In particular U.S. specification No. 3,993,123 shows an example of electrical apparatus comprising a module including a plurality of heat generating electrical components mounted on a substrate. A heat conduction cap or housing is sealed to the substrate and encloses the heat generating components. The wall of the housing opposite the substrate contains elongated openings or cylinders extending towards the heat generating components and on the same centres with respect thereto. A resilient member is located in each opening in the housing and acts against the inner end of the opening. A thermal conduction element or piston is located in each of the openings and is of a size to leave only a small peripheral gap between the peripheral opening wall and the associated thermal conduction element. Each resilient member urges its thermal conduction element into heat conducting pressure contact with the aligned heat generating component. A thermal conductive inert fluid is located within the cap or housing filling the peripheral gaps and any space in the interfaces between the heat generating elements and the thermal conduction elements. The heat is removed from the housing by external heat removal means e.g. a heat sink.

The conduction cooling scheme of U.S. Specification No. 3,993,123 is very efficient and keeps the electronic components to be cooled operating within their specific thermal limits. However, when low-power components are included with the high-power components within the same module or all low-power components are utilized, the cooling is too efficient for the low-power electronic components. That is, the low-power electronic components are essentially over-cooled. This means that a long time is required for low-power components to reach their desired operating temperature or they are maintained below their minimum desired operating temperature limit. The present invention is concerned with this problem of over-cooling low powered components.

The present invention provides electrical apparatus comprising a plurality of heat generating electrical components and a plurality of heat-conducting piston members respectively urged into contact with the components, slidably received in a plurality of cylinders or like openings in a heat-conducting housing and operative to conduct heat from the components to the housing, characterised in that the thermal resistance introduced by a first piston member 26a to the transfer of heat from its associated low powered component to the housing is greater than the thermal resistance introduced by a second piston member 26 to the transfer of heat from its associated high powered component to the housing.

One way of carrying out the claimed invention will now be described in detail by reference to various examples of electrical apparatus embodying the invention and illustrated in the accompanying drawings, in which:—

FIGURE 1 is a schematic cross-sectional view of a cooling module forming part of electrical apparatus embodying the invention and which includes several customized thermal conduction elements in the heat path of low-power electronic components.

FIGURE 2 is a cross-sectional view of a customized thermal conduction element located in the cooling path of a low-power electronic component to be cooled.

FIGURE 3 is a graph showing the total thermal resistance of the diminished diameter portion of the thermal conduction elements versus the length of the diminished diameter portion.

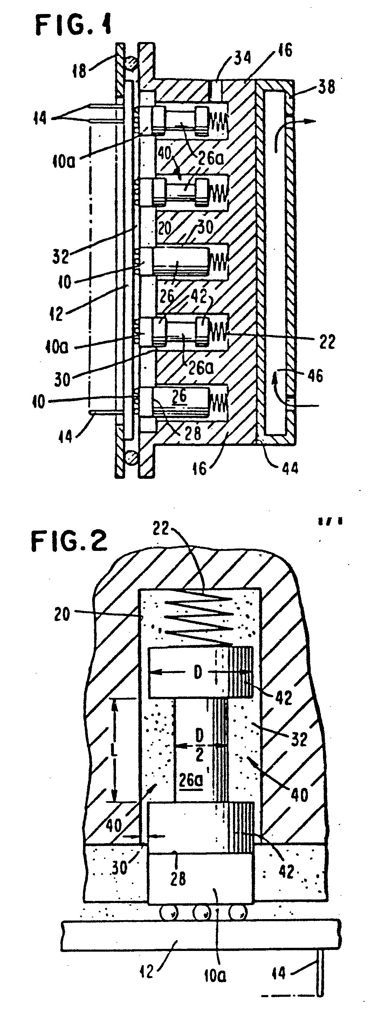

Referring to Figure 1, there is shown a cross-sectional view of a gas encapsulated module for providing cooling of heat generating electrical or electronic components shown in the form of chips 10. The chips 10 are integrated circuit components and consist of solid state circuits and devices which are densely packed on a semi-conductor substrate. The power dissipated in the circuits within the chip generates heat which must be removed from the chip. Since the various circuits have different power requirements and thus generate different amounts of heat, and since the integrated components thereon must be maintained within certain temperature ranges for reliable operation, the cooling must be of such character as to maintain the temperature of each chip within the required operating range.

The chips 10 are mounted on one of a substrate 12, generally made of ceramic, which has pins 14 extending from the other side thereof. These connecting pins 14 permit the module to be plugged into a board (not shown) which may very well carry auxiliary circuits, etc. A housing or cap 16 is attached to substrate 12 by means of a flange 18 which surrounds the periphery of the substrate 12. The cap 16 is made of a good heat conductive material such as copper or aluminum. The cap 16 is sufficiently thick to provide openings 20 opposite each of the losely spaced chips 10. Springs 22 are located at the inner end of each of the openings 20 and provide a spring force against a thermal conduction piston element 26 located in the opening 20. The spring force gives the piston element 26 a predetermined force at the outer end thereof where it contacts the back surface of the electronic chip 10 to be cooled. A small gap 30 exists between the circumference of the solid piston element 26 and the side walls of the hole 20 in the cap 16. The gap 30 is sufficiently wide to allow a little play of the element 26 within the hole 20 so that the element 26 can attain relatively flat surface engagement with the chip 10. It should be noted that the thermal conductive piston element 26 can co-act with chips 10 of various heights because of the resiliency of the spring member 22. Helium gas 32 is introduced into the open space between the substrate 12 and the cap 16. Helium gas is utilized for several reasons. The gas has a low molecular weight and thus easily fills any voids or spaces in the interface 28 between the thermal conductive piston elements 26 and chips 10. Similarly, the helium gas 32 fills the gap 30 between the periphery of the thermal conductive piston element 26 and the wall of the hole 20 thus forming a gaseous thermal conductive interface. Helium gas is a good thermal conductor and therefore forms an interface having high heat conductivity. That is, the interface formed using helium gas have a relatively low thermal resistance. Another feature of helium gas is that it is inert. By inert it is meant that the gas is electrically non-conductive, non-poisonous, non-corrosive, non-flammable, non-explosive and non-toxic. Helium gas also has a high adhesion quality that essentially wets the surface with which it is in contact. Other suitable low-molecular weight gases such as hydrogen or carbon dioxide could be used. As aforesaid, any voids or spaces in the pressure interface 28 are filled by the thermal conductive inert gas so that that interface provides a low-resistance to heat transfer. The gap 30 around the periphery of the thermal conduction elements 26 contains helium gas which provides a good thermal interface. As discussed above the module is designed to obtain the required heat transfer rate to maintain all the chips 10 within their required operating ranges. The heat accumulated in the thermal conductive material housing 16 from each of the thermal conductive elements 26, is transferred to a cold plate 38 which is attached to the cap 16. As can be seen from Figures 1, the surface of the cap 16 is relatively flat so that the cold plate 38 can be attached thereto with good thermal conductive relation. The cold plate 38 has a cooling liquid circulated therethrough which removes the heat transferred to the cold plate. The circulation is indicated by the arrow 46. The heat transfer path for removing heat from the heat generating electronic component chips 10 is across the interfaces 28 between the chips 10 and the piston conductive elements 26, through the piston conduction elements 26 and across the interface 30 between the circumference of these elements and the walls of the openings 20 within the cap 16. The heat is then conveyed through the cap 16 and through the interface between the top of the cap 16 and the wall of the cold plate 38. The heat moves through the wall of the cold plate 38 into the liquid 46 which flows through the cold plate 38 which is the ultimate heat sink.

As stated above, the rate of heat removal must be such as to keep the electronic components or chips 10 within their desired thermal operating range. We have found that low-power chips are maintained below their specified minimum operating temperature limit since those chips do not generate sufficient heat to reach their desired operating temperature when subject to the good thermal heat transfer path needed by high powered chips. This problem is solved in the present example by including customized thermal conduction elements 26a in the openings 20 in the housing 16 opposite low-power electronic components 10a to be cooled. The customizing consists of diminishing the diameter of a portion of the conduction cooling elements or piston 26a. This diminished diameter portion 40 extends along a predetermined length of the thermal conduction element 26a. The cutout portion of the thermal conduction element or the diminished diameter thereof may be located symmetrically about the centre of the length of the element. However, in the case of extremely low-power chips 10a the diminished diameter portion 40 can start at the end of the thermal conduction element 26a which abuts the chip 10a. This diminishes the area of the heat transfer interface 28 and thus further increases the thermal path resistance. The length L of the diminished diameter portion 40 is selected such that there is a full diameter section 42 at least at the spring end of the thermal conduction element 26a so that it is properly maintained within its opening 20. Thermal conductive elements having diminished diameter portions 40 are shown in Figure 1 as elements 26a and are associated with low-power chips identified as 10a. The thermal resistance paths for the higher power chips 10 are across the junction or interface gap 28 into a solid thermal conduction element 26. The heat is then transfered across the peripheral gap 30 between the thermal conduction element 26 and the housing 16 to the housing 16. The heat is then transfered through the housing 16, across the interface 44 between the cold plate 38 and the housing 16 and through the cold plate wall into the fluid flowing through the cold plate 38, such as water. The helium 32 provides good thermal conduction across the interfaces and gaps and thus, a highly efficient heat transfer path is provided. This transfer path through solid elements 26 is designed for the higher-power electronic components or chips 10 to be cooled. However, for lower-power chips 10a this transfer or cooling path is much too efficient. Since heat generated by low-powered chips 10a is removed with relative ease, i.e. at too high a rate, the operating temperature in some instances is never reached. In some cases, the warm-up time to reach operating temperature is excessive. The applicants appreciated that a way of making the heat transfer path for low-powered chips less efficient was needed. Diminishing or reducing the diameter of a portion of the thermal conduction element 26a in the heat transfer path of the low-power chips 10a, increases the resistance of that heat path and, if properly designed, will maintain the low-power chip 10a at an operatng temperature above the minimum operating temperature limits. The diminished diameter creates a larger gap 30 between the thermal conduction element 26a and the wall of the housing 16, thus increasing the thermal resistance of the gap. Thus, by diminishing the diameter the required amount and making the length of the diminished diameter the required length, the desired increase in resistance can be obtained. The required dimensions can be determined theoretically but are preferably determined by actual fabricating and measuring.

Figure 2 shows a schematic cross-sectional, enlarged view of a customized thermal conduction element 26a used with a low-power chip 10a. The diameter D shown across the end portions 42 therof is 0.54 cms, while the overall length of the element 26a is 1.59 cms. The gap between the end portions 42 of the thermal conduction element and the housing is equal to 0.0025 cms. The length of the cutout or diminished diameter portion 40 is identified by L and the diameter of the remaining portion of the thermal conduction element after the diameter has been diminished is equal to D/2. Utilizing these fixed parameters a graph or curve of the thermal characteristics of the thermal conduction element is obtained by plotting the total thermal resistance of the gap 30 or annulus in degrees celcius per wall against the length of the cutout portion in centimeters is plotted. It will be seen that as the length L of the diminished diameter portion 40 increases, the total thermal resistance of the gap 30 between the thermal conduction element 26a and the housing 16 increases. However when the length L of the diminished diameter portion 40 equals 1.27 cms, even a small increase in length of the diminished diameter portion 40 has a marked effect and causes a rapid increase in the total heat resistance added to the thermal path. It will be appreciated, that increasing the resistance of the thermal interface 30 between the thermal conduction element 26a and the housing 16 will increase the thermal resistance of the heat transfer or cooling path which will result in the chip 10a being operable at a higher temperature in accordance with the increase in thermal path resistance. This will also enable the chip to reach its increased operating temperature faster, thus, cutting down on any long warm-up period for the low-power chips.

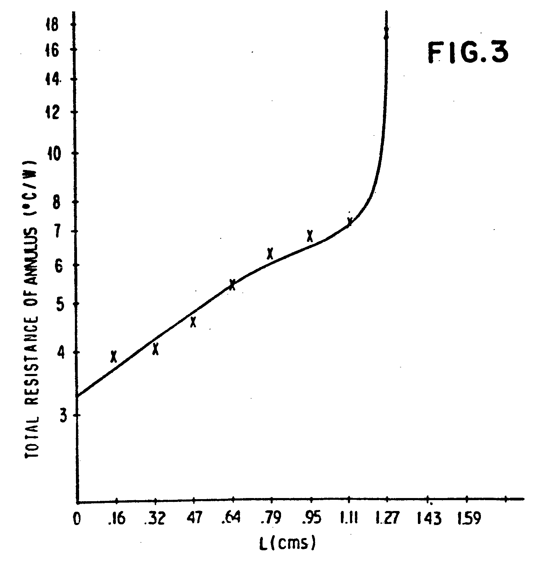

Copper thermal conduction elements 26a were used to obtain the graph of Figure 3. However, aluminium or other good thermal conductors could be used and the interface gaps 30 adjusted accordingly.

While the invention has been particularly shown and described with reference to the preferred embodiment thereof, it will be understood by those skilled in the art that the various changes in form and detail may be made. For instance the cold plate 36 can, where appropriate, be replaced by an air cooled heat sink. This may comprise fins on the housing 20.

## Claims

1. Electrical apparatus comprising a plurality of heat generating electrical components and a plurality of heat-conducting piston members respectively urged into contact with the components, slidably received in a plurality of cylinders or like openings in a heat-conducting housing and operative to conduct heat from the components to the housing, characterised in that the thermal resistance introduced by a first piston member (26a) to the transfer of heat from its associated low powered component to the housing is greater than the thermal resistance introduced by a second piston member (26) to the transfer of heat from its associated high powered component to the housing.

2. Electrical apparatus as claimed in claim 1, further characterised in that the first and second piston-members are of different cross-sectional area over at least a portion of their respective lengths.

3. Electrical apparatus as claimed in claim 1 or 2, in which the piston members are of circular cross-section, further characterised in that the first piston-member has at least a portion of reduced diameter.

4. Electrical apparatus as claimed in claim 3, in which said reduced diameter portion is symmetrically disposed in the length of the first piston-member to leave two full-diameter end portions.

5. Electrical apparatus as claimed in claim 3, in which said reduced diameter portion comprises the end portion of the first piston-member that contacts the component.

## Patentansprüche

1. Elektrische Vorrichtung mit einer Anzahl wärmeerzeugender, elektrischer Bauteile und einer Anzahl wärmeleitender, in einer Anzahl zylinderförmiger oder ähnlich geformter Öffnungen eines wärmeleitenden Gehäuses gleitend gelagerter kolbenförmiger Elemente, die in Berührung mit den elektrischen Bauteilen gedrängt sind und Wärme von den Bauteilen nach dem Gehäuse abführen, dadurch gekennzeichnet, daß der Wärmewiderstand eines ersten kolbenförmigen Elements (26a) für die Wärmeübertragung von dem zugeordneten Bauteil geringer Leistung nach dem Gehäuse größer ist, als der Wärmewiderstand eines zweiten kolbenförmigen Elements (26b) für die Wärmeübertragung von dem zugeordneten Bauteil hoher Leistung nach dem Gehäuse.

2. Elektrische Vorrichtung nach Anspruch 1, dadurch gekennzeichnet, daß das erste und das zweite kolbenförmige Element mindestens über einen Teil ihrer Länge verschieden große Querschnitte aufweisen.

3. Elektrische Vorrichtung nach den Ansprüchen 1 oder 2, dadurch gekennzeichnet, daß die kolbenförmigen Elemente kreisförmigen Querschnitt aufweisen und daß das erste kolbenförmige Element mindestens einen Abschnitt mit verringertem Durchmesser aufweist.

4. Elektrische Vorrichtung nach Anspruch 3, dadurch gekennzeichnet, daß der Abschnitt mit verringertem Durchmesser über die ganze Länge des kolbenförmigen Elements symmetrisch zwischen zwei Endabschnitten mit vollem Durchmesser angeordnet ist.

5. Elektrische Vorrichtung nach Anspruch 3, dadurch gekennzeichnet, daß der Abschnitt mit verringertem Durchmesser den in Berührung mit dem elektrischen Bauteil stehenden Abschnitt des kolbenförmigen Elements darstellt.

## Revendications

1. Appareil électrique comprenant plusieurs composants électriques générateurs de chaleur et plusieurs éléments pistons conducteurs de chaleur qui sont respectivement amenés en contact avec les composants, qui sont reçus de façon coulissable dans plusieurs cylindres, ou ouvertures semblables, faites dans un boîtier conducteur de chaleur et qui peuvent fonctionner de manière à conduire la chaleur depuis les composants jusqu'au boîtier, caractérisé en ce que la résistance thermique, qui est introduite par un premier élément piston 26a, au transfert de la chaleur depuis le composant à faible énergie qui lui est associé jusqu'au boîtier, est supérieure à la résistance thermique, qui est introduite par un second élément piston 26, au transfert de la chaleur depuis l'élément à énergie élevée qui lui est associé jusqu' au boîtier.

2. Appareil électrique selon la revendication 1, caractérisé en ce que les premier et second éléments pistons ont des surfaces transversales différentes sur au moins une portion de leur longueur.

3. Appareil électrique selon les revendications 1 ou 2, dans lequel les éléments pistons sont de coupe circulaire, caractérisé en outre en ce que le premier élément piston a au moins une portion dont le diamètre est réduit.

4. Appareil électrique selon la revendication 3, caractérisé en ce que la portion de diamètre réduite est symétriquement disposée sur la longueur du premier élément piston afin que le diamètre des portions extrêmes reste entier.

5. Appareil électrique selon la revendication 3, caractérise en ce que la portion ayant un diamètre réduit soit la portion extrême du premier élément piston qui fait contact avec le composant.

0 001 153

FIG. 1

FIG. 2

0 001 153

FIG.3